# EUROPEAN PATENT APPLICATION

(11) **EP 0 551 609 A1**
(43) Date of publication of application: **21.07.1993**
(21) Application number: 92120811.2
(22) Date of filing: 05.12.1992
(51) Int. Cl.: H03M 11/20, H03M 11/00

(54) **Methods and device for reading keyboards**

(30) Priority: 31.12.1991 ES 9102905
(71) Applicant: ALCATEL STANDARD ELECTRICA, S.A., E-28045 Madrid (ES)
(72) Inventor: Ruiz Merino, Francisco Javier, E-28030 Madrid (ES)
(74) Representative: Pohl, Herbert, Dipl.-Ing

(57) **Abstract**

Of the type which determines the key depressed and generates the corresponding code. For application preferably to data processing equipment.

Simplifies the generating and reading of codes, avoiding supervision from a microprocessor and pre-programming; to which end a key by key scanning process is done, synchronized with a counter whose values are used as codes of the validly depressed keys.

It includes, after an initiating command (1), a synchronized initialization stage (2) for the counter and the reading scan, a detection stage (3) of the validly depressed key which is followed by either a retention stage (4) of the counter value and a forwarding stage (5) of the valid code to the data bus when there is detection, or a counter incrementing stage (6) and reading of the next key when there is no detection; being also possible to access this stage (6) from the forwarding one (5). The next stage (7), determines whether or not there remain keys to be read, in order to return to the detection stage (3) or to the initialization stage (2), respectively, to repeat the cycle described.

## Description

### OBJECT OF THE INVENTION

This invention, as stated In the title of this document, refers to a method and a device for reading keyboards, with the purpose to simplify the method of reading keyboards and of generating the depressed key codes, so that it may be easily implemented in a specific integrated circuit.

To achieve the objectives indicated above, the invention proposes a cyclical method with various stages in which the scanning of the keyboard is done key by key, and in a synchronized manner with the stepping forward of a counter whose values are utilized as codes of the depressed keys.

The invention is applicable to the reading of any keyboard.

### BACKGROUND TO THE INVENTION

Systems are well-known for keyboard reading, based on taking advantage of part of the computing capacity of a microprocessor (present in the majority of electronic equipments that incorporate a user interfacing keyboard) and in the use of specific auxiliary integrated circuits such as the VIA (Versatile Interface Adapter), PIA (Peripheral Interface Adapter), or the like. These circuits and the microprocessor require pre-programming, the commands being stored in a ROM type memory.

These systems, as well as other examples of keyboard readers, that are currently implemented, can be found on pages 291 to 297 of the book "Digital Systems - Microprocessors Engineering", by A. Garcia Guerra, published by the E.T.S.I.T. in Madrid in 1986.

Keyboard reading methods based on a microprocessor, memory and VIA or PIA circuits, comprise the following stages:
1. Scanning the keys, which, in turn, can be broken down into:
   - cyclical activation of the rows in the key matrix;
   - reading the content of the set of columns for the enabled row, and
   - sending this content to the microprocessor.
2. The microprocessor determining if the key depressed is valid, and
3. Generating the code corresponding to the validly depressed key.

These methods have the inconvenience of employing a large number of electronic components (microprocessor, VIAs or PIAs, ROMs or RAMs, etc.), which also require a significant amount of prior programming.

On the other hand, if such methods were to be implemented in specific integrated circuits, the end result would not represent an optimum solution, as far as design time, integrated circuit surface employed and associated cost, and resulting circuit complexity, are concerned.

### TECHNICAL PROBLEM TO BE RESOLVED

Consequently, the technical problem to be overcome consists of simplifying the method for reading keyboards and for generating the depressed key codes, achieving a simple implementation of this in a specific integrated circuit.

### CHARACTERIZATION OF THE INVENTION

In order to overcome the inconveniences mentioned, the invention consists of a method and a device for reading keyboards, in which the scanning of the keyboard is done key by key in synchronism with the stepping of a counter, using the value in the counter as code of the valid depressed key.

The method is characterized in that, after an initializing command, it consists of a synchronized initialization stage of a key by key reading process in a predetermined order, and of a depressed key code generator/counter. Then, the detection of the depressed key occurs and, in the event, the determining of the validity of the depressed key. If a valid depressed key is detected, the value of the code generator/counter is retained, and this value is forwarded as a valid depressed key code to a data bus.

When the forwarding of the valid depressed key code to the data bus has occurred, or if the key depressed before was not depressed in a valid manner (not depressed or depressed incorrectly), the addressing of the next key to be read takes place along with the incrementing of the code generator/counter.

Finally, it is determined whether the next key to be read still belongs to the current keyboard scan, in which case the detection stage is resumed, or, on the other hand, if it belongs to a new scan, in which case the process is repeated starting from the initialization stage.

With this method there is no requirement, unlike any currently known methods, for any kind of pre-programming, or supervision, or communication or additional coding.

The device is characterized in that it has a code generator/counter that is connected to an identifier of codes to be inhibited and to a key scanning generator. This key scanning generator is also connected to the keyboard and to a general controller.

The device is also characterized in that the identifier of codes to be inhibited is also connected to an N-bit comparator and to the general controller. The N-bit comparator is also connected to an N-bit buffer and to the general controller.

Another characteristic of the device is that the N-bit buffer is connected to through-connecting gates and to the general controller. These gates are also connected to the data bus.

The characteristics mentioned, with reference both to the device and to the method, offer the following advantages:
- suppression of the independent stage to generate the depressed key code by including it in the key scanning stage,
- reduction in the number of components,
- no need for supervision from the microprocessor, nor for pre-programming, and, consequently, independence for both the reading and coding of the keys,
- the design permits scaling to the size required by simply repeating the existing structure as often as necessary (function of the number of keys to be used),
- easy to implement inside a specific integrated circuit.

Next, to make it easier to understand this document and forming an integral part thereof, some figures are attached, which illustrate but in no way limit what the object of the invention represents.

### BRIEF FOOTNOTES TO THE FIGURES

Figure 1 shows a flowchart illustrating the steps or stages that comprise the method of this invention.

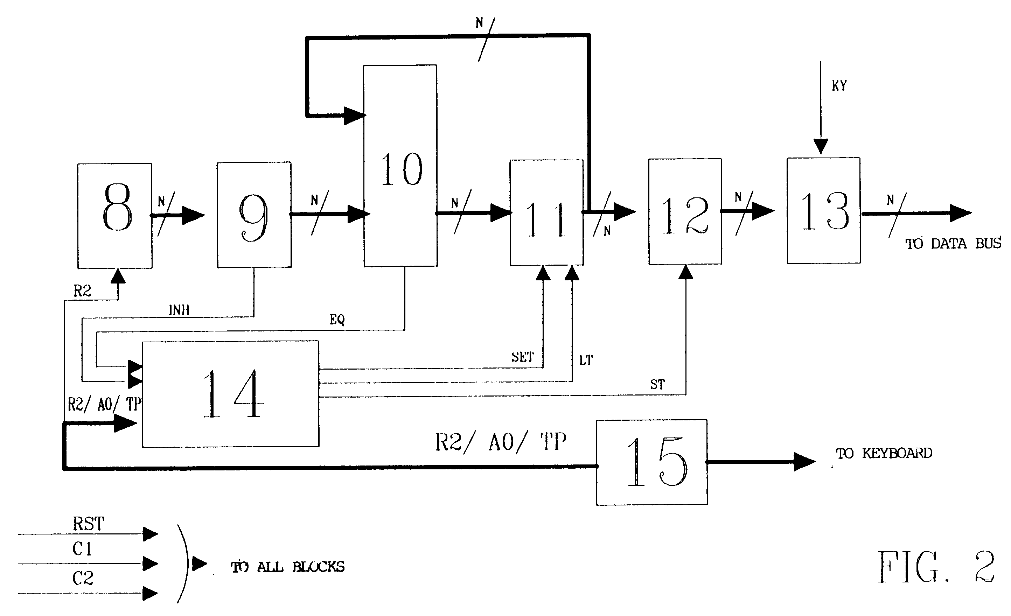

Figure 2 shows a block diagram of a preferred implementation of a device to permit the method of the invention to be put into practice.

### DESCRIPTION OF THE INVENTION

A description is now given of the invention making reference to the numbering adopted for the figures.

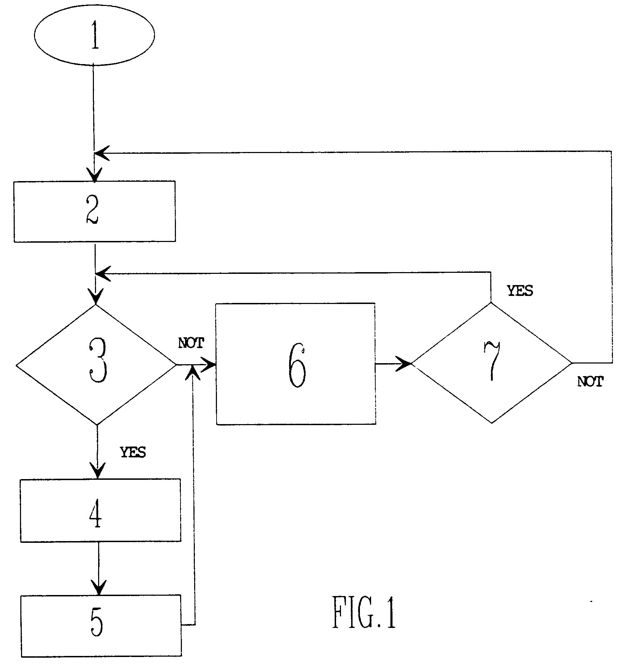

Hence, the method consists of a series of stages that are repeated cyclically as is shown in figure 1: after receiving an initializing command 1, there is a synchronized initialization stage 2 for key by key reading in a predetermined order and for a depressed key code generator/counter. The next stage 3 consists of the detection of the depressed key and in determining if the depressed key is valid. If, in this stage 3, a valid depressed key is detected, the value of the code generator/counter stage is passed to a buffer stage, and then to a forwarding or transmitting stage 5 that sends the code of the validly depressed key to a data bus.

If, in stage 3, no validly depressed key is detected, the method moves directly to stage 6 to increment the code generator/counter and to read the next key. Otherwise, this stage 6 is accessed after stage 5.

Following, there is a stage 7 which determines whether the next key to be read does or does not belong to the scanning of the keyboard in course. If it does, stage 3 is resumed, if not, the system returns to initialization stage 2.

The device of the invention has a series of blocks by means of which the method described above is implemented.

Thus, block 8 is the code generator/counter; it is an N-bit counter with direct resetting to zero or initialization. The initial value after restoring to zero can be other than zero, depending on the code from which it is wished to commence. It counts according to clock C1.

Block 9 is the identifier of codes to be inhibited. It permits the synchronization between the code generator/counter 8 and the keyboard scanning. Block 9 generates a signal, INH, that activates when one of these codes appears. This signal permits the scanning of the keyboard to be frozen in those intervals and the inhibition of any keys that are depressed. This task is done by means of three-state buffers 13 and a general controller 14.

Block 10 is an N-bit comparator and its output signal EQ indicates when the content of the counter 8 is equal to the content of the code that is being held in the N-bit buffer 11. The EQ signal is employed in the general controller 14 to comply with the established requirements.

The N-bit buffer 11 is set to one/zero directly by means of the control signal SET. Whenever this signal activates, the buffer 11 retains the value of the code for non-depressed key. This serves internally to initialize the process of key detection. On the other hand, every time a clocking edge LT is applied to it, it will retain the information coming from the comparator 10.

Block 12 consists of through-connecting gates that normally permit the transfer of the content held in block 11, however, when the signal ST activates, the code at its output is set to non-depressed key.

The three-state buffers 13 permit the code information to be left in the corresponding data bus, for which the signal KY has to activate.

Up to now, all the blocks described are for N-bits. Concerning their layout for forming part of an integrated circuit, a design can be made for a single bit, and this repeated N times.

The general controller 14 has the job of generating all the control signals described above. To do this, it receives the signals IHQ, EQ, R2, AO and TP generated by blocks 9, 10 and 15, in addition to the signals C1, C2 and RST that are applied to all functional blocks. In this block 14, circuits that perform the functional requirements for the recognition of the keys by means of specific electronic circuitry are located. The number of components it holds is relatively small, depending on the functionality wished to grant the keyboard (time between one keystroke and another, minimum depression time, maximum depression break time, etc.). This general controller 14 has the job of generating the control signals SET, LT and ST.

Block 15 is the key scanning generator which can be implemented by means of two nested ring counters, such that one has the job of scanning the columns and the other the rows of the keyboard. Each key is read only once during each cycle, and the interval of time for each keyboard read cycle is inversely proportional to the clock rate C1.

Now, in order to provide a better understanding of the invention, an example is given of how the reading of a key would take place and how its code would be output over the data bus. To simplify, first imagine that all the codes are valid and that none have to be suppressed, that is, the INH signal is never enabled.

A start can be made with the enabling of the RST signal, which initializes all blocks (8 to 15). From this point, the code generator counter 8 begins to count from the initial value and, in turn, the keyboard begins to be scanned in a determined order.

As the counting proceeds in block 8, the number of the key being observed, to see if it is being depressed also advances. After examining the last key, a new internal initialization takes place by means of the R2 signal, and the scanning mechanism is resumed.

The way in which the code retention is done and its subsequent insertion on the data bus, is as follows: the information on the codes is kept in block 11 if it satisfies the specific timing requirements imposed for each keyboard while the corresponding key is being depressed. When the code is considered to be valid, block 12 ceases to present the code for non-depressed key at its output and permits the passage of the information held in block 11.

The control and generation of the signals that operate the blocks mentioned, are achieved by means of the general controller 14, as has already been stated.

Whenever the KY signal is enabled from an external source, the information on the corresponding code shall be passed to the data bus from the rest of the external system.

To see how the circuit acts with the INH signal, imagine that it is necessary to suppress a code. Initially the circuit would operate as described earlier, however when the prohibited code appears in the counter 8, the INH signal would become activated. This signal would stop the scanning of the keyboard during the corresponding interval of time, and would cancel any keystroke. After the prohibited code, the next valid code would arrive, the INH signal would be disabled, and the mechanism for scanning and recognition of keys would again continue to operate from the earlier position at which it was detained.

## Claims

1. **METHOD FOR READING KEYBOARDS** of the type that comprises the stages of key scanning, determination of valid keystrokes and generation of valid keystroke code, characterized:
- in that the scanning of the keyboard is done key by key,
- in that the scanning is done in synchronism with the stepping of a counter, and
- in that the value in the counter is used as code of the valid depressed key.

2. **METHOD FOR READING KEYBOARDS** according to claim 1, characterized in that the method, after an initializing command (1) comprises the following stages:
- a synchronized initialization (2) of key by key reading in a predetermined order, and of a depressed key code generator/counter,
- the detection (3) of the depressed key and, in the event, the determination of the depressed key as valid,
- if a valid depressed key is detected in the detection stage (3), the value of the code generator/counter is retained (4),
- the code corresponding to valid depressed key, generated in the previous stage, is forwarded (5) to a data bus,
- addressing of the next key to be read takes place along with the incrementing of the code generator/counter (6) once the forwarding of the preceding valid depressed key code has occurred, or when the key depressed before was not depressed in a valid manner (not depressed or depressed incorrectly), and
- determining whether the next key to be read belongs to the current keyboard scan (7) or not:
· if it still belongs to the keyboard scan in course, the detection stage (3) is resumed,
· if it belongs to a new scan, the process is repeated starting from the initialization stage (2).

3. **DEVICE FOR READING KEYBOARDS** to carry out the method claimed above, characterized:
- in that the initializing command consists of an external signal (RST) that is applied to each and every one of the functional blocks of the device,
- in that the synchronized initialization (2) of the key by key reading in a predetermined order and of a depressed key code generator/counter, the addressing of the next key to be read and the incrementing of the code counter/generator (6), and the determining of whether the next key to be read does or does nor belong to the keyboard scan in course (7), are done by means of a code generator/counter (8) and a key scanning generator (15),
- in that the code generator/counter (8), which is an N-bit counter with direct initialization, is connected to an identifier of codes to be inhibited (9) and to the key scanning generator (15) from which it receives a reset to zero signal (R2), and is initialized synchronously in the synchronized initialization stage (2), is incremented in value in stage (6) and is reinitialized if, in stage (7), it is detected that the new key to be read belongs to a new keyboard scan, and
- in that the key scan generator (15), that is formed by two counters, is also connected to the keyboard and to the general controller (14), and is initialized synchronously in the stage of synchronized initialization (2), the file and column counters are incrementing in accordance with the arrangement of the keys, and is reinitialized if in stage (7) it is detected that the new key to be read belongs to a new keyboard scan.

4. **DEVICE FOR READING KEYBOARDS**, according to claim 3, characterized besides:
- in that the detection (3) of a valid keystroke and retention (4) of the value of the code generator/counter, is achieved by means of an identifier of codes to be inhibited (9), an N-bit comparator (10), an N-bit buffer (11) and a general controller (14),
- in that the identifier of codes to be inhibited (9) is connected, as well as to the code generator/counter (8), to the N-bit comparator (10) and to the general controller (14) to which it sends a signal (INH) that is enabled whenever any of the codes to be inhibited appears and which permits freezing of the keyboard scan and inhibition of the keys depressed, and in stage 3 detects if any of the codes of those generated by the code generator/counter (8) have not to be used as a key code, enabling for this the INH signal,
- in that the N-bit comparator (10) is also connected to the N-bit buffer (11) and to the general controller (14) to which it sends the signal (EQ) that indicates when the content of the code generator/counter (8) is equal to the content of the code held in the N-bit buffer (11),
- in that the N-bit buffer (11) is connected to through-connecting gates (12) and to the general controller (14) from which it receives a clock signal (LT) and a control signal (SET), and permits stage (3) to be carried out, retaining the previous value to compare it with the current one, and
- in that the general controller (14) is also connected to the through-connecting gates (12) and generates all the control signals (SET, LT, ST).

5. **DEVICE FOR READING KEYBOARDS** according to claim 3, characterized besides:
- in that the forwarding (5) of the code corresponding to the valid keystroke to a data bus, is done by means of a set of through-connecting gates (12) and a set of tri-state buffers (13),
- in that the through-connecting gates (12) are connected to a set of tri-state buffers (13) and permit transfer of the content held in the N-bit buffer (11), except for the case in which the signal ST activates, in which event, the code of non-depressed key appears at their output, and
- in that the set of tri-state buffers (13) is also connected to the data bus where the information on the code is left when they are authorized for this.
